# FASCICULE DE BREVET EUROPEEN

(11) **EP 2 589 679 B1**
(45) Date de publication et mention de la délivrance du brevet: **29.08.2018**
(21) Numéro de dépôt: 12190710.9
(22) Date de dépôt: 31.10.2012
(51) Int. Cl.: B82Y 30/00, B82Y 40/00, C23C 10/52, C23C 16/24, C23C 28/04, H01L 21/02, H01L 29/06, C23C 16/56, C23C 16/02, C23C 28/00, C01B 32/184

(54) **PROCÉDÉ DE SYNTHÈSE D'UN FEUILLET DE GRAPHÈNE SUR UN SILICIURE DE PLATINE, STRUCTURES OBTENUES PAR CE PROCÉDÉ ET LEURS UTILISATIONS**
VERFAHREN ZUR SYNTHESE EINES GRAPHENBLATTS AUF EINEM PLATINSILIZID, DURCH DIESES VERFAHREN ERHALTENE STRUKTUREN UND IHRE VERWENDUNGEN
METHOD FOR SYNTHESISING A GRAPHENE SHEET ON A PLATINUM SILICIDE, STRUCTURES OBTAINED BY SAID METHOD AND USES THEREOF

(30) Priorité: 07.11.2011 FR 1160126
(43) Date de publication de la demande: 08.05.2013
(73) Titulaire: Commissariat à l'Énergie Atomique et aux Énergies Alternatives, 75015 Paris (FR)
(72) Inventeur: Zenasni, Aziz, 38610 Gières (FR)
(74) Mandataire: Ilgart, Jean-Christophe

(56) Documents cités:
- EP-A1- 2 055 673
- EP-A2- 2 281 779
- FR-A1- 2 946 663

## Description

### DOMAINE TECHNIQUE

L'invention se rapporte au domaine de la fabrication de feuillets de graphène.

Plus spécifiquement, l'invention se rapporte à un procédé permettant de synthétiser un feuillet, mono- ou multicouche, de graphène sur un siliciure de platine, de formule Pt*ₓ*Si, ce siliciure de platine se présentant sous la forme d'une couche ou d'une pluralité de plots espacés les uns des autres.

Elle se rapporte également aux structures obtenues par ce procédé ainsi qu'aux utilisations de ces structures.

Ces structures sont susceptibles d'être utilisées telles quelles dans tous les domaines techniques où la fabrication de contacts électroniques et électriques est recherchée, en particulier dans les domaines de la micro- et de la nanoélectronique ainsi que de la micro- et de la nanoélectromécanique, par exemple pour la fabrication de systèmes électromécaniques de taille micrométrique ou nanométrique, communément désignés par les sigles MEMS (pour « *Micro Electro-Mechanical Systems* ») et NEMS (pour « *Nano Electro-Mechanical Systems* »).

### ÉTAT DE LA TECHNIQUE ANTÉRIEURE

Le graphène est un cristal bidimensionnel de carbone, qui présente une structure hexagonale en nid d'abeille.

Ce cristal est doté de propriétés tout à fait surprenantes qui en font actuellement un matériau très prisé de nombreux laboratoires publics et privés.

En effet, le graphène présente, en premier lieu, une mobilité électronique exceptionnelle à température ambiante, pouvant atteindre 20 m²/(V·s). À titre de comparaison, la mobilité électronique de l'antimoniure d'indium InSb est, à la température ambiante, deux fois et demie plus faible, celle du silicium est treize fois plus faible tandis que celle de l'argent est deux mille cinq cents fois plus faible.

De plus, le graphène est transparent puisque son épaisseur, qui est celle d'un atome de carbone, est de l'ordre de l'angström (0,1 nm). En outre, il allie légèreté, haute stabilité chimique et résistance mécanique élevée (typiquement, deux cents fois supérieure à celle de l'acier).

On connaît un certain nombre de techniques permettant de synthétiser des feuillets de graphène comme l'exfoliation micromécanique d'un cristal de graphite, la réduction électrochimique d'un oxyde de graphène, l'ouverture de nanotubes de carbone, la croissance catalytique du graphène sur substrat métallique ou la sublimation d'un carbure de silicium.

Parmi ces techniques, la croissance catalytique du graphène sur couche métallique paraît constituer l'une des voies les plus prometteuses pour synthétiser du graphène à une échelle industrielle et permettre son intégration dans des dispositifs de micro- ou nanoélectronique, de micro- ou nanoélectro-mécanique ou autres, qui répondent aux normes industrielles.

En effet, par cette technique, il a été possible de produire des échantillons de graphène de haute qualité cristalline, caractérisée par des domaines monocristallins s'étendant sur plusieurs centaines de micromètres et par une orientation cristallographique unique à l'échelle macroscopique. Des échantillons de graphène aux surfaces centimétriques ont même été obtenus, ce qui n'est pas le cas avec les autres techniques de fabrication du graphène proposées à ce jour.

Dans sa version initiale, la croissance catalytique du graphène sur couche métallique se fonde sur l'exposition d'une couche d'un métal, par exemple de nickel, de cuivre ou d'iridium, chauffé à haute température, c'est-à-dire environ 1000°C, à des espèces carbonées en phase gazeuse. Selon la solubilité du carbone dans le métal formant la couche métallique et son aptitude à diffuser dans ce métal, on obtient la formation sur cette couche métallique d'un feuillet de graphène à une ou plusieurs couches de graphène.

Il a ainsi été obtenu des feuillets monocouches et bicouches de graphène sur une couche de nickel (Reina et al., Nano Res 2009, 2, 509-516, **[1]**), et des feuillets monocouches de graphène sur une couche de cuivre (Li et al., Science 2009, 47, 2026-2031, **[2]**) et sur un monocristal de platine (Sutter et al., Phys. Rev. B 2009, 80, 245411, **[3]**).

Il est ensuite possible d'éliminer la couche métallique par une gravure chimique et de transférer le feuillet de graphène ainsi isolé de cette couche sur une nouvelle couche.

Plus récemment, Hofrichter et al. (Nano Lett. 2010, 10(1), 36-42, **[4]**) ont montré qu'il est possible de synthétiser du « polygraphène », c'est-à-dire un feuillet de graphène comprenant qui comprend des zones à une seule couche de graphène et des zones à quelques couches de graphène, sur une couche de nickel en utilisant non plus des espèces carbonées en phase gazeuse mais une source solide de carbone, en l'occurrence une couche de carbure de silicium amorphe.

On connaît également par EP-A-2 281 779 un procédé de synthèse de graphène par traitement thermique d'un empilement qui comprend un substrat, une couche d'un matériau carboné solide, une couche d'un catalyseur métallique et, éventuellement, une couche d'un matériau céramique de type oxyde, carbure, borure, nitrure ou siliciure, cette couche étant destinée à créer un motif soit au contact du substrat soit au-dessus de la couche de catalyseur métallique.

On connaît, par ailleurs, l'intérêt des couches minces de siliciures de platine.

Les propriétés semi-conductrices de ces siliciures sont couramment utilisées dans les domaines de la radioastronomie et de l'électronique, notamment pour la création de zones de contact entre le silicium et une ou plusieurs couches de métaux superposées, l'amélioration de contacts ohmiques dans les technologies MOS (pour « *Métal Oxide Semiconductors* ») et CMOS (pour « *Complementary Métal Oxide Semiconduc-tors* »), et la réalisation de diodes Schottky. Citons encore l'importance des siliciures de platine dans la conception de détecteurs à infrarouge et de caméras thermiques destinées à l'imagerie médicale, ou encore la mise en oeuvre de procédés de nano-lithogravure.

On comprend, dès lors, qu'il serait intéressant de disposer de structures comprenant un feuillet de graphène sur une couche mince d'un siliciure de platine, de manière à conjuguer les qualités du graphène à celles de ce type de siliciure.

Il se trouve qu'à la connaissance de l'inventeur, aucun document de l'état de la technique ne décrit la synthèse d'un feuillet de graphène sur un siliciure de platine. Toutefois, une voie de synthèse d'un feuillet monocouche de graphène sur un siliciure de nickel a été récemment décrite dans la littérature (Juang et al., Carbon 2009, 47, 2026-2031, **[5]**).

Dans cette référence, la couche de carbure de silicium est déposée sur un substrat de silicium, puis recouverte de la couche de nickel et la structure ainsi formée est soumise à un traitement thermique qui permet au carbone de se dissoudre dans le nickel, formant ainsi une couche de siliciure de nickel, située à l'interface des couches de carbure de silicium et de nickel. La constitution de cette couche de siliciure de nickel entre en compétition avec un phénomène de migration du carbone en direction de la surface de la couche de nickel, l'ensemble contribuant à la synthèse, par croissance catalytique, d'un feuillet de graphène sur cette surface.

*A priori,* ce procédé ne paraît pas applicable à la synthèse d'un feuillet de graphène sur un siliciure de platine, puisqu'il est fondé sur les propriétés de solubilité et de diffusion du carbone dans le métal et qu'en l'espèce, le carbone est très peu soluble dans le platine.

L'inventeur s'est donc fixé pour but général de fournir un procédé qui permette de synthétiser un feuillet de graphène sur un siliciure de platine.

L'inventeur s'est également fixé pour but que ce procédé permette d'obtenir aussi bien un feuillet de graphène multicouche qu'un feuillet de graphène monocouche.

L'inventeur s'est en outre fixé pour but que cette synthèse puisse être réalisée aussi bien sur un siliciure de platine se présentant sous la forme de plots espacés les uns des autres que sur un siliciure de platine se présentant sous la forme d'une couche et, dans ce dernier cas, qu'elle conduise à un feuillet de graphène dont la surface, c'est-à-dire la superficie, ne soit limitée que par les dimensions de la couche de siliciure de platine et ce, quelles que soient les dimensions de cette couche.

Enfin, l'inventeur s'est fixé pour but que cette synthèse soit rapide et ne fasse appel qu'à des traitements thermiques modérés.

### EXPOSÉ DE L'INVENTION

Ces buts et d'autres encore sont atteints par l'invention qui propose, en premier lieu, un procédé de synthèse d'un feuillet de graphène sur un siliciure de platine, de formule Pt*ₓ*Si, dans laquelle *x* représente un nombre supérieur ou égal à deux, lequel procédé est caractérisé en ce qu'il comprend :
a) la réalisation d'un empilement par :
   i) dépôt sur un substrat d'une couche C1 d'un matériau barrière de diffusion choisi parmi les oxydes et les nitrures ;
   ii) dépôt sur la couche C1 d'une couche C2 d'un matériau carboné, ledit matériau carboné pouvant comprendre du silicium ;
   iii) dépôt sur la couche C2 d'une couche C3 de platine ; et
   iv) dans le cas où le matériau carboné utilisé à la sous-étape ii) est exempt de silicium, le dépôt sur la couche C3 d'une couche C4 d'un matériau de formule Si*ₐ*C*_{b}*H*_{c}* dans laquelle *a* représente un nombre strictement positif tandis que *b* et *c*, identiques ou différents, représentent des nombres positifs ou nuls ; puis
b) le traitement thermique à une température comprise entre 200°C et 900°C de l'empilement obtenu à l'issue de l'étape a),
et en ce que le matériau carboné se décompose à la température à laquelle est réalisé le traitement thermique et le rapport du nombre d'atomes de platine présents dans la couche C3 au nombre d'atomes de silicium présents dans la couche C2 ou la couche C4 est supérieur ou égal à deux.

Ainsi, selon l'invention, la synthèse du feuillet de graphène se fonde sur une croissance catalytique de ce graphène à partir d'une source solide carbonée, l'inventeur ayant en effet constaté que, contre toute attente et tout préjugé, il est tout à fait possible de faire croître du graphène sur un siliciure d'un métal dans lequel le carbone est peu ou très peu soluble, comme le platine.

L'inventeur a, de plus, constaté qu'en jouant sur les modalités de mise en oeuvre des étapes a) et b) précitées, il est possible d'obtenir un feuillet de graphène aussi bien multicouche que monocouche, qui s'étend :
- soit sur une couche de siliciure de platine ;
- soit sur une pluralité de plots de siliciure de platine, espacés les uns des autres ;
et ce, en des temps extrêmement courts, typiquement inférieurs à dix minutes, et en utilisant des températures qui ne dépassent pas 900°C.

Ainsi, conformément à l'invention, le siliciure de platine peut se présenter sous la forme d'une couche ou sous la forme d'une pluralité de plots espacés les uns des autres.

Comme précédemment mentionné, le procédé comprend tout d'abord une étape a) dans laquelle on prépare un empilement comprenant successivement un substrat, une couche C1 de matériau barrière de diffusion, une couche C2 de matériau carboné pouvant comprendre du silicium, une couche C3 de platine et, éventuellement, une couche C4 de matériau Si*ₐ*C*_{b}*H*_{c}* lorsque le matériau carboné de la couche C2 est exempt de silicium.

Le substrat peut être de différents types mais doit présenter une température de fusion supérieure à la température à laquelle est réalisé le traitement thermique de l'étape b).

Il s'agit typiquement d'un substrat de silicium, compte tenu de la température de fusion élevée du silicium (1414°C à la pression atmosphérique), de la disponibilité et du faible coût de ce type de substrat. Toutefois, il peut également s'agir d'un substrat de germanium ou de quartz.

La couche C1 de matériau barrière de diffusion a pour fonction d'empêcher le carbone présent dans la couche C2 de diffuser vers le substrat et, inversement, d'empêcher le matériau constitutif du substrat de diffuser vers la couche C2.

Le matériau barrière de diffusion est choisi parmi les oxydes tels que le dioxyde de silicium SiO₂, ou encore parmi les nitrures tels que le nitrure de tantale TaN et le nitrure de titane TiN.

Avantageusement, le matériau barrière de diffusion est du dioxyde de silicium en raison de ce que ce dernier permet d'obtenir des couches exemptes de toute rugosité. Ce dioxyde de silicium est déposé sous la forme d'une couche, préférentiellement par dépôt chimique en phase vapeur (ou CVD), cette technique permettant, en effet, de particulièrement bien contrôler la qualité de la couche C1 obtenue.

La couche C2 de matériau carboné a pour fonction de fournir les espèces carbonées qui sont à la base de la croissance du feuillet de graphène.

Conformément à l'invention, le matériau carboné doit pouvoir se décomposer à la température choisie pour effectuer le traitement thermique de l'étape b), c'est-à-dire à une température comprise entre 200°C et 900°C, de manière à libérer le carbone qu'il contient.

Ainsi, le matériau carboné peut notamment être choisi parmi les matériaux carbonés amorphes qui sont exempts de silicium et, en particulier, parmi le carbone amorphe, le carbone amorphe hydrogéné a-C:H, les polymères amorphes exclusivement hydrocarbonés du type de celui des hydrocarbures saturés (paraffine), des polyoléfines, choisies en particulier parmi les polyéthylènes, les polypropylènes, les polybutylènes, les polybutadiènes, les polystyrènes, les polyisoprènes de synthèse, le caoutchouc naturel, les copolymères d'isoprène-*iso*-butylène (encore connus sous le nom de caoutchoucs butyles), les copolymères d'éthylène-butylène-diène (ou EPDM), les copolymères séquencés de styrène-isoprène-styrène (ou SIS), les copolymères séquencés de styrène-éthylène-butylène-styrène (ou SEBS), et les mélanges de ceux-ci.

En variante, le matériau carboné peut également être choisi parmi les matériaux carbonés amorphes qui comprennent du silicium, auquel cas on préfère, pour des raisons qui sont explicitées ci-après, que ce matériau présente une proportion massique de silicium supérieure ou égale à 20% de la masse totale de ce matériau. De manière encore plus avantageuse, cette proportion massique est supérieure ou égale à 40% de la masse totale de ce matériau.

Typiquement, un matériau carboné amorphe comprenant du silicium répondant à ces critères est un carbure de silicium amorphe hydrogéné de formule a-Si*_{α}*C*_{β}*:H, dans laquelle *α* et *β*, identiques ou différents, représentent des nombres strictement positifs.

Selon la nature du matériau carboné, celui-ci peut être déposé sous la forme d'une couche par des techniques telles que :
- le dépôt chimique en phase vapeur (ou CVD), sous toutes ses formes : CVD à pression atmosphérique (ou APCVD), CVD basse pression (ou LPCVD), CVD sous vide poussé (ou UHVCVD), CVD assisté par aérosol (ou AACVD), CVD par injection directe liquide (ou DLICVD), CVD thermique rapide (ou RTCVD), CVD initié (ou i-CVD), CVD par couche atomique (ou ALCVD), CVD à fil chaud (ou HWCVD), CVD assisté par plasma (ou PECVD), CVD assisté par plasma déporté (ou RPECVD), CVD assisté par plasma micro-ondes (ou MWPCVD), etc. ;
- le dépôt physique en phase vapeur (ou PVD), sous toutes ses formes : PVD par pulvérisation cathodique (par exemple, magnétron, à triode, magnétron pulsé à haute puissance), PVD par évaporation sous vide, PVD par pulvérisation par faisceau d'ions (ou IBS), PVD par arc, par exemple cathodique, dépôt par laser pulsé (ou PLD), etc. ;
- le dépôt hybride physico-chimique en phase vapeur (ou HPCVD) ;
- le dépôt par procédé sol-gel, plus particulièrement par voie liquide, l'enduction centrifuge (ou « *spin coating* » en langue anglaise), l'enduction laminaire et le trempage-retrait (ou « *dip coating* » en langue anglaise).

Conformément à l'invention, la couche C2 est, de préférence, une couche de carbone amorphe hydrogéné ou d'un carbure de silicium amorphe hydrogéné de formule a-Si*_{α}*C*_{β}*:H dans laquelle *α* et *β* sont tous les deux égaux à 1, que l'on dépose préférentiellement par un dépôt chimique en phase vapeur assisté par plasma (ou PECVD), dans lequel la pression utilisée est sous-atmosphérique tout en étant supérieure à 10⁻⁶ Pa.

La couche C3 de platine a, elle, pour fonction de catalyser la croissance du feuillet de graphène, par l'intermédiaire de la formation d'une couche de siliciure de platine, que nous évoquons ci-après.

Afin d'obtenir une couche C3 parfaitement continue, le dépôt de cette couche est, de préférence, réalisé par l'une quelconque des techniques de dépôt chimique ou physique en phase vapeur précédemment mentionnées.

Toutefois, on préfère que la technique utilisée soit un dépôt physique en phase vapeur (ou PVD), cette technique permettant, en effet, de favoriser la création de structures colonnaires au sein de la couche C3.

Ces structures, subsistant au sein de la couche de siliciure de platine après constitution de cette dernière, permettent la migration du carbone, qui est libéré par la couche C2 au cours de l'étape b), vers la surface du siliciure de platine, et, partant, la formation du feuillet de graphène.

Par ailleurs, le dépôt de la couche C3 est effectué à une température allant de 10 à 35°C, de préférence de 20 à 30°C, et mieux encore, à une température de (25 ± 1)°C.

Le procédé selon l'invention comprend le dépôt additionnel, sur la couche de platine, d'une couche C4 d'un matériau de formule Si*ₐ*C*_{b}*H*_{c}* dont les indices *a*, *b* et c sont tels que définis précédemment, ce dépôt additionnel n'étant réalisé que dans le cas où le matériau carboné déposé à la sous-étape ii) est exempt de silicium.

Avantageusement, la couche C4 est une couche de silicium amorphe hydrogéné a-Si:H, que l'on dépose préférentiellement par un dépôt chimique en phase vapeur assisté par plasma (ou PECVD), dans lequel la pression utilisée est sous-atmosphérique tout en étant supérieure à 10⁻⁶ Pa.

Par ailleurs, le procédé selon l'invention comprend une étape b) dans laquelle l'empilement obtenu à l'issue de l'étape a) est soumis à un traitement thermique.

Le traitement thermique est effectué en poursuivant plusieurs objectifs.

D'une part, le traitement thermique permet la formation d'une couche de siliciure de platine, à l'interface de la couche de platine et de la couche de matériau comprenant du silicium, indépendamment du fait que ce matériau ait été déposé à la sous-étape ii) ou à la sous-étape iv) du procédé selon l'invention. Cette couche de siliciure de platine peut notamment être caractérisée par réalisation d'un cliché de diffraction des rayons X, duquel l'homme du métier peut aisément déduire la stoechiométrie avec laquelle le platine est présent dans Pt*ₓ*Si.

D'autre part, le traitement thermique permet la décomposition du matériau carboné en espèces carbonées, dont la diffusion à travers la couche de siliciure de platine est facilitée par l'existence, à l'échelle microscopique, de structures colonnaires qui sont conservées après formation de la couche de siliciure de platine, comme évoqué précédemment.

En outre, le traitement thermique permet la réaction catalytique propre à conduire à la formation du feuillet de graphène. En effet, après diffusion des espèces carbonées au travers de la couche de siliciure de platine, ces espèces sont localisées sur l'ensemble de la surface de cette couche qui est opposée à celle en contact avec la couche C1. Il se forme alors, sur cette surface, des noyaux de graphène (phénomène de nucléation) qui en s'étendant, finissent par se rejoindre et par former, par coalescence, un feuillet continu de graphène.

Enfin, le traitement thermique participe, conjointement avec la température à laquelle est déposée la couche C3, à maintenir la couche de siliciure de platine à l'état de couche ou à induire, par un phénomène de démouillage, la transformation de cette couche de siliciure de platine en une pluralité de plots espacés les uns des autres.

Divers paramètres exercent une influence sur la diffusion des espèces carbonées à travers la couche de siliciure de platine, et, par conséquent, sur les propriétés du feuillet de graphène synthétisé.

Ainsi, dans le but de synthétiser un siliciure de platine de formule Pt*ₓ*Si, dans laquelle *x* représente un nombre supérieur ou égal à deux, il importera à l'homme du métier de choisir, de manière judicieuse, les épaisseurs des couches C2, C3 et éventuellement C4 déposées, ou encore la proportion massique de silicium dans la couche C2 ou la couche C4.

Par exemple, lorsque le matériau carboné amorphe utilisé à la sous-étape ii) comprend du silicium, en une proportion supérieure ou égale à 20% de la masse totale du matériau, l'inventeur a pu mettre en évidence, à l'issue du traitement thermique, la formation majoritaire d'une couche de Pt*ₓ*Si, dans laquelle *x* représente un nombre supérieur ou égal à deux. Dans ce cas, l'inventeur a constaté une diffusion très rapide des espèces carbonées du matériau solide carboné à travers la couche de siliciure.

De surcroît, l'inventeur a noté une amplification de cette rapidité de diffusion pour une proportion supérieure ou égale à 40% de la masse totale du matériau.

Par ailleurs, les températures de dépôt des couches C2, C3 et, le cas échéant, C4 et de traitement thermique ont également leur importance. Aussi, et comme il est exposé ci-après dans les deux modes de mise en oeuvre du procédé selon l'invention, le traitement thermique est-il réalisé à des températures suffisamment élevées pour permettre, d'une part, la formation d'un siliciure de platine, d'autre part, la décomposition du matériau carboné de la couche C2, et enfin, la réaction catalytique conduisant à la formation du feuillet de graphène, tout en étant inférieures à la température à laquelle l'un au moins des autres constituants de l'empilement est susceptible de se dégrader.

Selon un premier mode de mise en oeuvre, le traitement thermique est réalisé à une température allant de 700 à 900°C, de préférence de 750 à 850°C, et mieux encore, à une température de (800 ± 5)°C.

Dans ces conditions, le traitement thermique semble induire, en premier lieu, la formation d'une couche de siliciure de platine. Après diffusion des espèces carbonées du matériau carboné de la couche C2 à travers la couche de siliciure, la formation du feuillet de graphène s'opère sur la surface de cette couche de siliciure.

De manière consécutive à la formation de ce feuillet de graphène, et à de telles températures, un phénomène de démouillage de la couche de siliciure de platine paraît s'opérer.

Ce phénomène, qui est favorisé par le dépôt de la couche de platine à basse température, typiquement à une température allant de 10 à 35°C comme explicité ci-dessus, consiste en un retrait de la couche de siliciure de platine située en dessous du feuillet de graphène, qui s'effectue simultanément en divers endroits de cette couche. Ce retrait s'effectue sans une quelconque perte de matière.

À l'issue du traitement thermique, on obtient alors un feuillet de graphène muni, sur l'une de ses surfaces, d'une pluralité de plots de siliciure de platine espacés les uns des autres.

En complément, la disposition du feuillet de graphène vis-à-vis des couches sous-jacentes du nouvel empilement obtenu à l'issue de l'étape b), c'est-à-dire les couches de substrat, de matériau barrière de diffusion et le siliciure de platine, peut être modifiée et ajustée selon les usages auxquels le feuillet de graphène est destiné.

Ainsi, par exemple, la couche C1 de matériau barrière de diffusion peut être structurée, après son dépôt, selon un motif déterminé sur tout ou partie de son épaisseur, moyennant quoi le démouillage de la couche de siliciure de platine s'effectue en fonction de ce motif. Dans ce cas, il est notamment possible, en ajustant l'épaisseur de la couche C3 de platine, d'obtenir, à l'issue du traitement thermique, un feuillet de graphène se trouvant localement au contact de la couche C1.

Selon un second mode de mise en oeuvre, le traitement thermique comprend :
- un premier traitement thermique qui est réalisé à une température allant de 250 à 350°C ; et qui est suivi par
- un deuxième traitement thermique qui est réalisé à une température allant de 750 à 850°C.

Les conditions modérées de température mises en jeu dans le premier traitement thermique conduisent à la formation d'une couche de siliciure de platine, les espèces carbonées du matériau carboné ne subissant aucune dégradation.

Ainsi, à l'issue de ce premier traitement thermique, il se forme une couche de siliciure de platine Pt*ₓ*Si recouvrant la couche de matériau carboné déposé à la sous-étape ii) du procédé selon l'invention.

Les conditions plus élevées de température mises en jeu dans le deuxième traitement thermique permettent la diffusion des espèces carbonées du matériau carboné à travers la couche de siliciure de platine, à la surface de laquelle ces espèces contribuent à la formation du feuillet de graphène, en mettant en jeu le phénomène de nucléation précédemment explicité,

En outre, et ce, quel que soit le mode de mise en oeuvre du procédé selon l'invention considéré, le traitement thermique est, de préférence, réalisé sous une atmosphère neutre, c'est-à-dire ni oxydante, ni réductrice, choisie par exemple parmi l'argon, l'hélium, le diazote, et leurs mélanges.

Ainsi, le procédé selon l'invention permet, à l'issue des étapes a) et b), la formation d'un feuillet de graphène sur un siliciure de platine, qui peut être contrôlée par spectroscopie Raman, notamment en vérifiant l'apparition des deux pics caractéristiques du graphène, à savoir le pic G à 1580 cm⁻¹ et le pic 2D à 2700 cm⁻¹. Le rapport de l'intensité du pic 2D, que l'on note I_{2D}, à celle du pic G, que l'on note I_{G}, permet alors d'évaluer le nombre de couches de graphène que comprend le feuillet de graphène synthétisé (voir, par exemple, Reina et al., Nano Lett. 2009, 9(1), 30-35, **[6]**).

L'invention a également pour objet une structure qui comprend, dans l'ordre qui suit :
- un substrat;
- une couche C1 d'un matériau barrière de diffusion choisi parmi les oxydes et les nitrures ;
- un siliciure de platine, de formule Pt*ₓ*Si, *x* représentant un nombre supérieur ou égal à deux, ce siliciure se présentant sous la forme d'une couche ou d'une pluralité de plots espacés les uns des autres ; et
- un feuillet de graphène.

Dans cette structure, les caractéristiques préférées du substrat, du matériau barrière de diffusion et du siliciure de platine sont telles que précédemment décrites en relation avec le procédé.

Conformément à l'invention, le feuillet de graphène peut être un feuillet mono- ou multicouche, préférence étant donnée à un feuillet multicouche, c'est-à-dire comprenant au moins deux couches de graphène.

La structure selon l'invention est susceptible d'être utilisée telle quelle, c'est-à-dire sans subir une quelconque transformation complémentaire, dans un dispositif micro- ou nanoélectronique, par exemple pour servir de contacts électriques, de points mémoire et de mémoires résistives, ou dans un dispositif électromécanique de taille micrométrique ou nanométrique (MEMS ou NEMS).

En variante, la structure selon l'invention est également susceptible d'être utilisée dans la fabrication d'une structure qui n'est formée que du feuillet de graphène et d'un siliciure de platine, se présentant sous la forme d'une couche ou d'une pluralité de plots espacés les uns des autres, auquel cas cette utilisation comprend l'élimination, par exemple par gravure chimique, du substrat et de la couche C1.

Comme expliqué dans l'exposé de l'état de la technique ci-avant, une structure formée uniquement d'un feuillet, mono- ou multicouche, de graphène sur un siliciure de platine, de formule Pt*ₓ*Si, *x* représentant un nombre supérieur ou égal à deux, n'a jamais été réalisée à ce jour.

Aussi, l'invention a-t-elle encore pour objet une structure qui comprend un feuillet de graphène comportant au moins une couche de graphène, ladite couche étant munie, sur l'une de ses faces, d'un siliciure de platine, de formule Pt*ₓ*Si, *x* représentant un nombre supérieur ou égal à deux, ce siliciure se présentant sous la forme d'une couche ou d'une pluralité de plots espacés les uns des autres.

L'invention a en outre pour objet l'utilisation d'une structure telle que précédemment définie dans la fabrication d'un dispositif micro- ou nanoélectronique, ou micro- ou nanoélectromécanique.

D'autres caractéristiques et avantages de l'invention ressortiront du complément de description qui suit, qui se rapporte à des exemples de mise en oeuvre du procédé selon l'invention et qui se réfère aux figures annexées.

Il va de soi que ces exemples ne sont donnés qu'à titre d'illustrations de l'objet de l'invention et ne constituent en aucun cas une limitation de cet objet.

### BRÈVE DESCRIPTION DES FIGURES

Les Figures 1A à 1F illustrent, sous une forme schématique, un premier mode de mise en oeuvre du procédé selon l'invention.
Les Figures 2A à 2D illustrent, sous une forme schématique, un deuxième mode de mise en oeuvre du procédé selon l'invention.
La Figure 3 est un cliché obtenu par microscopie électronique à balayage (grossissement de 13 000 fois) qui montre partiellement une structure obtenue par le deuxième mode de mise en oeuvre du procédé selon l'invention.

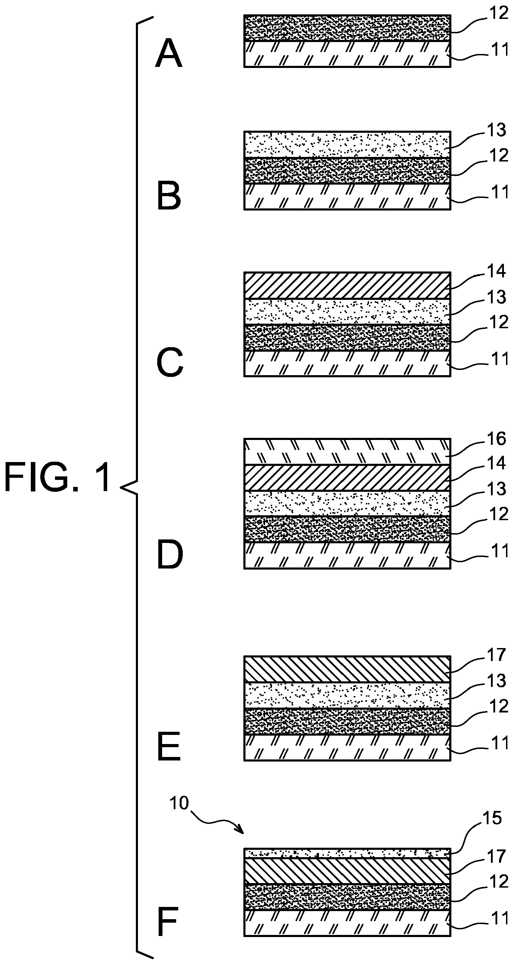

Pour des raisons de clarté, les dimensions des différents éléments représentés sur les Figures 1A à 1F d'une part, et 2A à 2D d'autre part, ne sont pas en proportion avec leurs dimensions réelles.

### EXPOSÉ DÉTAILLÉ DE MODES DE MISE EN OEUVRE PARTICULIERS

### Exemple 1: Synthèse d'une structure comprenant un feuillet de graphène sur une couche d'un siliciure de platine

On se réfère aux Figures 1A à 1F qui illustrent, de manière schématique, un premier mode de mise en oeuvre du procédé selon l'invention, conçu pour fabriquer une structure qui comprend un feuillet de graphène sur une couche de siliciure de platine.

Ce procédé comprend :
a) comme visible sur la Figure 1A, le dépôt, sur un substrat 11, par exemple de silicium, d'une couche 12 d'un matériau barrière de diffusion, par exemple une couche de dioxyde de silicium SiO₂ ; puis
b) comme visible sur la Figure 1B, le dépôt, sur la couche 12 de matériau barrière de diffusion, d'une couche 13 d'un matériau carboné, par exemple une couche de carbure amorphe hydrogéné a-C:H ; puis
c) comme visible sur la Figure 1C, le dépôt, sur la couche 13 de matériau carboné, d'une couche 14 de platine ; puis
d) comme visible sur la Figure 1D, le dépôt, sur la couche 14 de platine, d'une couche 16 d'un matériau comprenant du silicium, par exemple de silicium amorphe hydrogéné a-Si:H ; puis
e) le traitement thermique de l'empilement formé à l'issue des étapes a) à d), ce traitement thermique étant réalisé en deux étapes.

On obtient ainsi l'empilement qui est illustré sur la Figure 1E et qui ne comprend plus les couches 14 et 16 mais qui, par contre, comprend une couche 17 d'un siliciure de platine Pt*ₓ*Si, puis la structure 10 qui est illustrée à la Figure 1F et qui ne comprend plus de couche 13 mais qui, par contre, comprend un feuillet de graphène 15 qui s'étend sur toute la surface de la couche 17 de Pt*ₓ*Si.

Les étapes de ce premier mode de mise en oeuvre du procédé selon l'invention sont décrites de manière détaillée ci-après.

On dépose, sur une plaque de silicium de 200 mm de diamètre, une couche de SiO₂ d'environ 100 nm d'épaisseur par CVD, à une température de 1100°C et sous une atmosphère composée de 95% de diazote et de 5% de dioxygène.

Puis, on dépose sur la couche de SiO₂ ainsi obtenue une couche d'environ 40 nm d'épaisseur de a-C:H par PECVD, à partir de propène et d'hélium, par exemple dans un réacteur à couplage capacitif du type Centura™ 5200 DxZ de la société Applied Materials, et en utilisant les paramètres opératoires suivants :
- excitation radiofréquence : 13,56 MHz ;
- pression de travail : 2 torrs (266 Pa) ;
- puissance d'alimentation du plasma : 200 W ;
- température de dépôt : 250°C ;
- flux de propène : 410 cm³/minute ;
- flux d'hélium : 700 cm³/minute ;
- durée du dépôt : 27 secondes.

On dépose ensuite, sur cette couche de a-C:H, une couche de platine d'environ 100 nm d'épaisseur par PVD par pulvérisation cathodique, en utilisant les paramètres opératoires suivants :
- pression de travail : 50 torrs (6,66 kPa) ;
- puissance d'alimentation du plasma : 200 W ;
- température de dépôt : 25°C ;
- flux d'argon : 500 cm³/minute ;
- durée du dépôt : 1 minute.

Enfin, on dépose sur la couche de platine ainsi obtenue une couche d'environ 44 nm d'épaisseur de a-Si:H par PECVD, à partir de silane, de dihydrogène et d'hélium, par exemple dans un réacteur identique à celui qui est utilisé pour le dépôt de la couche de a-C:H, et en utilisant les paramètres opératoires suivants :
- excitation radiofréquence : 13,56 MHz ;
- pression de travail : 4 torrs (533 Pa) ;
- puissance d'alimentation du plasma : 500 W ;
- température de dépôt : 350°C ;
- flux de silane : 490 cm³/minute ;
- flux de dihydrogène : 100 cm³/minute ;
- flux d'hélium : 500 cm³/minute ;
- durée du dépôt : 13 secondes.

Une fois ce dépôt réalisé, l'ensemble est placé pendant 30 minutes dans une enceinte chauffée à 300°C sous un flux d'argon de 1000 cm³/minute.

On obtient ainsi un empilement tel qu'illustré schématiquement sur la Figure 1E et qui comprend, sur une plaque 11 de silicium, une couche 12 de SiO₂, une couche 13 de a-C:H et une couche 17 de siliciure de platine Pt*ₓ*Si.

Cette couche de siliciure de platine a pu être caractérisée. En effet, la réalisation d'un cliché de diffraction des rayons X a permis de mettre en évidence la stoechiométrie du siliciure constituant la couche 17. Il s'agit de siliciure de triplatine Pt₃Si.

L'empilement est ensuite placé pendant 15 minutes dans une enceinte chauffée à 800°C, par exemple un four vertical, sous un flux d'argon de 1000 cm³/minute.

On obtient ainsi une structure telle qu'illustrée schématiquement sur la Figure 1F et qui comprend, sur une plaque 11 de silicium, une couche 12 de SiO₂, une couche 17 de Pt₃Si et un feuillet 15 de graphène qui s'étend sur toute la surface de la couche de platine.

Ce feuillet de graphène présente une épaisseur d'un nanomètre et comprend trois couches de graphène.

### Exemple 2 : Synthèse d'une structure comprenant un feuillet de graphène sur une pluralité de plots d'un siliciure de platine

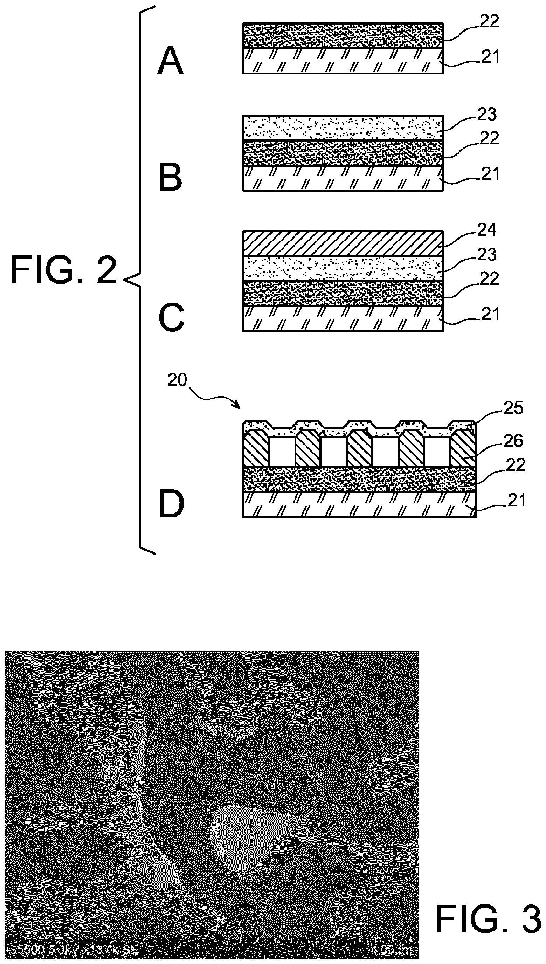

On se réfère aux Figures 2A à 2D qui illustrent, de manière schématique, un second mode de mise en oeuvre du procédé selon l'invention, conçu pour fabriquer une structure qui comprend un feuillet de graphène sur une pluralité de plots de siliciure de platine.

Ce procédé comprend :
a) comme visible sur la Figure 2A, le dépôt, sur un substrat 21, par exemple de silicium, d'une couche 22 d'un matériau barrière de diffusion, par exemple une couche de dioxyde de silicium SiO₂; puis
b) comme visible sur la Figure 2B, le dépôt, sur la couche 22 du matériau barrière de diffusion, d'une couche 23 d'un matériau carboné comprenant du silicium, par exemple une couche de carbure de silicium amorphe hydrogéné a-SiC:H ; puis
c) comme visible sur la Figure 2C, le dépôt, sur la couche 23 du matériau carboné, d'une couche 24 de platine ; puis
d) un traitement thermique de l'empilement formé à l'issue des étapes a) à c), à l'issue duquel on obtient la structure 20 qui est illustrée à la Figure 2D et qui ne comprend plus de couche 23 mais qui, par contre, comprend un feuillet de graphène 25 sur une pluralité de plots 26 d'un siliciure de platine Pt*ₓ*Si, ces plots étant espacés les uns des autres.

Les étapes de ce second mode de mise en oeuvre du procédé selon l'invention sont décrites de manière détaillée ci-après.

On dépose une couche de SiO₂ sur une plaque de silicium, de 200 mm de diamètre, dans les mêmes conditions opératoires que celles exposées dans l'Exemple 1 ci-avant.

Puis, on dépose sur la couche de SiO₂ ainsi obtenue une couche d'environ 40 nm d'épaisseur de a-SiC:H par PECVD, à partir de triméthylsilane, de propène et d'hélium, par exemple dans un réacteur identique à celui utilisé dans l'Exemple 1, et en utilisant les paramètres opératoires suivants :
- excitation radiofréquence : 13,56 MHz ;
- pression de travail : 8,7 torrs (1,16 kPa) ;
- puissance d'alimentation du plasma : 550 W ;
- température de dépôt : 250°C ;
- flux de triméthylsilane : 150 cm³/minute ;
- flux de propène : 410 cm³/minute ;
- flux d'hélium : 700 cm³/minute ;
- durée du dépôt : 7 secondes.

Après quoi, on dépose sur cette couche de a-SiC:H une couche de platine d'environ 100 nm d'épaisseur par PVD par pulvérisation cathodique, en utilisant les paramètres opératoires suivants :
- pression de travail : 50 torrs (6,66 kPa) ;
- puissance d'alimentation du plasma : 200 W ;
- température de dépôt : 25°C ;
- flux d'argon : 500 cm³/minute ;
- durée du dépôt : 1 minute.

Une fois ce dépôt réalisé, l'ensemble est placé pendant 15 minutes dans une enceinte chauffée à 800°C sous un flux d'argon de 1000 cm³/minute.

Les plots de siliciure de platine ont pu être caractérisés. En effet, la réalisation d'un cliché de diffraction des rayons X a permis de mettre en évidence la stoechiométrie avec laquelle le platine est présent dans le siliciure de platine constituant la pluralité de plots 26. Il s'agit de siliciure de triplatine Pt₃Si.

On obtient ainsi une structure telle qu'illustrée schématiquement sur la Figure 2D et qui comprend, sur une plaque 21 de silicium, une couche 22 de SiO₂, une pluralité de plots 26 de Pt₃Si et un feuillet 25 de graphène muni, sur l'une de ses faces, de la pluralité de plots 26 de Pt₃Si, ces plots étant espacés les uns des autres.

Ce feuillet de graphène présente une épaisseur d'un nanomètre et comprend trois couches de graphène.

Un cliché de la surface d'une telle structure, à la Figure 3, a été réalisé par microscopie électronique à balayage. Ce cliché permet d'observer, par l'intermédiaire d'une ouverture pratiquée dans le feuillet de graphène, la géométrie et la répartition aléatoire, ou non ordonnée, des plots 26 de Pt₃Si disposés sur la couche 22 de SiO₂.

L'invention ne se limite pas aux modes de mise en oeuvre du procédé selon l'invention qui viennent d'être décrit et illustrés dans les exemples.

Ainsi, par exemple, il est tout à fait possible de réaliser, sur des empilements tels que ceux présentés aux Figures 1E et 2C :
α) le dépôt d'une couche C1' de matériau barrière de diffusion ;
β) le dépôt d'une couche C2' de matériau carboné sur la couche C1', ledit matériau carboné pouvant comprendre du silicium ;
γ) le dépôt d'une couche C3' de platine sur la couche C2' ; puis
δ) éventuellement, le dépôt d'une couche C4' de matériau Si*ₐ*C*_{b}*H*_{c}* sur la couche C3', lorsque le matériau carboné utilisé à la sous-étape β) est exempt de silicium,
étant précisé que l'ensemble des étapes α), β), γ) et δ) peut être répété une ou plusieurs fois;
et de soumettre le nouvel empilement ainsi constitué à un traitement thermique, en une ou deux étapes, tel que précédemment décrit.

On obtient, de la sorte, une structure comprenant une pluralité de feuillets de graphène, chacun de ces feuillets étant situé sur une couche de siliciure de platine ou sur une pluralité de plots de siliciure de platine espacés les uns des autres.

### RÉFÉRENCES CITÉES

**[1]** Reina et al., Nano Res 2009, 2, 509-516
**[2]** Li et al., Science 2009, 47, 2026-2031
**[3]** Sutter et al., Phys. Rev. B 2009, 80, 245411
**[4]** Hofrichter et al., Nano Lett. 2010, 10(1), 36-42
**[5]** Juang et al., Carbon 2009, 47, 2026-2031
**[6]** Reina et al., Nano Lett. 2009, 9(1), 30-35

## Revendications

1. Procédé de synthèse d'un feuillet de graphène sur un siliciure de platine, de formule Pt*ₓ*Si dans laquelle *x* représente un nombre supérieur ou égal à deux, lequel procédé est **caractérisé en ce qu'**il comprend :
a) la réalisation d'un empilement par :
i) dépôt sur un substrat d'une couche C1 d'un matériau barrière de diffusion choisi parmi les oxydes et les nitrures ;
ii) dépôt sur la couche C1 d'une couche C2 d'un matériau carboné, ledit matériau carboné pouvant comprendre du silicium ;
iii) dépôt sur la couche C2 d'une couche C3 de platine ; et
iv) dans le cas où le matériau carboné utilisé à la sous-étape ii) est exempt de silicium, le dépôt sur la couche C3 d'une couche C4 d'un matériau de formule Si*ₐ*C*_{b}*H*_{c}* dans laquelle *a* représente un nombre strictement positif tandis que *b* et *c*, identiques ou différents, représentent des nombres positifs ou nuls ; puis
b) le traitement thermique à une température comprise entre 200°C et 900°C de l'empilement obtenu à l'issue de l'étape a) ;
et **en ce que** le matériau carboné se décompose à la température à laquelle est réalisé le traitement thermique et le rapport du nombre d'atomes de platine présents dans la couche C3 au nombre d'atomes de silicium présents dans la couche C2 ou la couche C4 est supérieur ou égal à deux.

2. Procédé selon la revendication 1, **caractérisé en ce que** le matériau barrière de diffusion est du dioxyde de silicium.

3. Procédé selon la revendication 1 ou la revendication 2, **caractérisé en ce que** le matériau carboné est choisi parmi les matériaux carbonés amorphes.

4. Procédé selon la revendication 3, **caractérisé en ce que** le matériau carboné amorphe comprend du silicium, en une proportion massique supérieure ou égale à 20% de la masse totale dudit matériau.

5. Procédé selon la revendication 4, **caractérisé en ce que** le matériau carboné amorphe comprend du silicium, en une proportion massique supérieure ou égale à 40% de la masse totale dudit matériau.

6. Procédé selon la revendication 4 ou la revendication 5, **caractérisé en ce que** le matériau carboné amorphe comprenant du silicium est un carbure de silicium amorphe hydrogéné de formule a-Si*_{α}*C*_{β}*:H dans laquelle *α* et *β*, identiques ou différents, représentent des nombres strictement positifs.

7. Procédé selon la revendication 6, **caractérisé en ce que** le carbure de silicium amorphe hydrogéné a pour formule a-Si*_{α}*C*_{β}*:H dans laquelle *α* et *β* sont tous deux égaux à 1.

8. Procédé selon la revendication 3, **caractérisé en ce que** le matériau carboné amorphe est un matériau exempt de silicium.

9. Procédé selon la revendication 8, **caractérisé en ce que** le matériau exempt de silicium est du carbone amorphe hydrogéné a-C:H.

10. Procédé selon l'une quelconque des revendications précédentes, **caractérisé en ce que** la couche C2 est déposée par dépôt chimique en phase vapeur assisté par plasma.

11. Procédé selon l'une quelconque des revendications précédentes, **caractérisé en ce que** la couche C3 est déposée par dépôt physique en phase vapeur, à une température allant de 20°C à 30°C.

12. Procédé selon la revendication 8 ou la revendication 9, **caractérisé en ce que** le matériau de formule Si*ₐ*C*_{b}*H*_{c}* est du silicium amorphe hydrogéné a-Si:H.

13. Procédé selon la revendication 12, **caractérisé en ce que** la couche de a-Si:H est déposée par dépôt chimique en phase vapeur assisté par plasma.

14. Procédé selon l'une quelconque des revendications 1 à 13, **caractérisé en ce que** le traitement thermique est réalisé à une température allant de 750°C à 850°C, sous une atmosphère neutre.

15. Procédé selon l'une quelconque des revendications 1 à 13, **caractérisé en ce que** le traitement thermique comprend :
- un premier traitement thermique qui est réalisé à une température allant de 250°C à 350°C, sous une atmosphère neutre ; et qui est suivi par
- un deuxième traitement thermique qui est réalisé à une température allant de 750°C à 850°C, sous une atmosphère neutre.

16. Structure, **caractérisée en ce qu'**elle comprend, dans l'ordre qui suit :
- un substrat;
- une couche C1 d'un matériau barrière de diffusion choisi parmi les oxydes et les nitrures ;
- un siliciure de platine, de formule Pt*ₓ*Si dans laquelle *x* représente un nombre supérieur ou égal à deux, ce siliciure se présentant sous la forme d'une couche ou d'une pluralité de plots espacés les uns des autres ; et
- un feuillet de graphène.

17. Structure selon la revendication 16, **caractérisée en ce que** le matériau barrière de diffusion est du dioxyde de silicium.

18. Structure selon la revendication 16 ou la revendication 17, **caractérisée en ce que** le feuillet de graphène comprend au moins deux couches de graphène.

19. Structure, **caractérisée en ce qu'**elle comprend un feuillet de graphène, ledit feuillet étant muni, sur l'une de ses faces, d'un siliciure de platine, de formule Pt*ₓ*Si dans laquelle *x* représente un nombre supérieur ou égal à deux, ce siliciure se présentant sous la forme d'une couche ou d'une pluralité de plots espacés les uns des autres.

20. Utilisation d'une structure telle que définie dans l'une quelconque des revendications 16 à 19, dans la fabrication d'un dispositif micro- ou nanoélectronique, ou micro- ou nanoélectromécanique.

## Patentansprüche

1. Verfahren zur Synthese eines Graphenblatts auf einem Platinsilicid mit der Formel PtₓSi, wobei x eine Zahl größer oder gleich zwei darstellt, wobei das Verfahren **dadurch gekennzeichnet ist, dass** dieses umfasst:
a) die Herstellung eines Stapels durch:
i) Abscheidung einer Schicht C1 aus einem Diffusionssperrmaterial, ausgewählt aus Oxiden und Nitriden, auf einem Substrat;
ii) Abscheidung einer Schicht C2 aus einem kohlenstoffhaltigen Material auf der Schicht C1, wobei das kohlenstoffhaltige Material Silicium umfassen kann;
iii) Abscheidung einer Schicht C3 aus Platin auf der Schicht C2; und
iv) in dem Fall, wo das in dem Teilschritt ii) verwendete kohlenstoffhaltige Material kein Silicium aufweist, Abscheidung einer Schicht C4 aus einem Material mit der Formel SiₐC_{b}H_{c} auf der Schicht C3, wobei a eine streng positive Zahl darstellt, während b und c, identisch oder verschieden, positive Zahlen oder null darstellen; anschließend
b) thermische Behandlung des am Ende von Schritt a) erhaltenen Stapels bei einer Temperatur zwischen 200°C und 900°C;
und dadurch, dass sich das kohlenstoffhaltige Material bei der Temperatur zersetzt, bei der die thermische Behandlung durchgeführt wird, und das Verhältnis der Anzahl von Platinatomen, die in der Schicht C3 vorhanden sind, zur Anzahl von Siliciumatomen, die in der Schicht C2 oder der Schicht C4 vorhanden sind, größer oder gleich zwei ist.

2. Verfahren nach Anspruch 1,
**dadurch gekennzeichnet, dass** das Diffusionssperrmaterial Siliciumdioxid ist.

3. Verfahren nach Anspruch 1 oder Anspruch 2,
**dadurch gekennzeichnet, dass** das kohlenstoffhaltige Material aus amorphen kohlenstoffhaltigen Materialien ausgewählt wird.

4. Verfahren nach Anspruch 3,
**dadurch gekennzeichnet, dass** das amorphe kohlenstoffhaltige Material Silicium in einem Massenanteil größer oder gleich 20 % der Gesamtmasse des Materials umfasst.

5. Verfahren nach Anspruch 4,
**dadurch gekennzeichnet, dass** das amorphe kohlenstoffhaltige Material Silicium in einem Massenanteil größer oder gleich 40 % der Gesamtmasse des Materials umfasst.

6. Verfahren nach Anspruch 4 oder Anspruch 5,
**dadurch gekennzeichnet, dass** das amorphe kohlenstoffhaltige Material, das Silicium umfasst, ein hydriertes amorphes Siliciumcarbid mit der Formel a-Si_{α}C_{β}:H ist, wobei α und β, identisch oder verschieden, streng positive Zahlen darstellen.

7. Verfahren nach Anspruch 6,
**dadurch gekennzeichnet, dass** das hydrierte amorphe Siliciumcarbid die Formel a-Si_{α}C_{β}:H aufweist, wobei α und β beide gleich 1 sind.

8. Verfahren nach Anspruch 3,
**dadurch gekennzeichnet, dass** das amorphe kohlenstoffhaltige Material ein Material ist, das kein Silicium aufweist.

9. Verfahren nach Anspruch 8,
**dadurch gekennzeichnet, dass** das Material, das kein Silicium aufweist, hydrierter amorpher Kohlenstoff a-C:H ist.

10. Verfahren nach einem der vorhergehenden Ansprüche,
**dadurch gekennzeichnet, dass** die Schicht C2 durch chemische Dampfphasenabscheidung mit Plasmaunterstützung abgeschieden wird.

11. Verfahren nach einem der vorhergehenden Ansprüche,
**dadurch gekennzeichnet, dass** die Schicht C3 durch physikalische Dampfphasenabscheidung bei einer Temperatur von 20°C bis 30°C abgeschieden wird.

12. Verfahren nach Anspruch 8 oder Anspruch 9,
**dadurch gekennzeichnet, dass** das Material mit der Formel SiₐC_{b}H_{c} hydriertes amorphes Silicium a-Si:H ist.

13. Verfahren nach Anspruch 12,
**dadurch gekennzeichnet, dass** die Schicht aus a-Si:H durch chemische Dampfabscheidung mit Plasmaunterstützung abgeschieden wird.

14. Verfahren nach einem der Ansprüche 1 bis 13,
**dadurch gekennzeichnet, dass** die thermische Behandlung bei einer Temperatur von 750°C bis 850°C unter einer neutralen Atmosphäre durchgeführt wird.

15. Verfahren nach einem der Ansprüche 1 bis 13,
**dadurch gekennzeichnet, dass** die thermische Behandlung umfasst:
- eine erste thermische Behandlung, die bei einer Temperatur von 250°C bis 350°C unter einer neutralen Atmosphäre durchgeführt wird; und die gefolgt wird von
- einer zweiten thermischen Behandlung, die bei einer Temperatur von 750°C bis 850°C unter einer neutralen Atmosphäre durchgeführt wird.

16. Struktur, **dadurch gekennzeichnet, dass** diese in der folgenden Reihenfolge umfasst:
- ein Substrat;
- eine Schicht C1 aus einem Diffusionssperrmaterial, ausgewählt aus Oxiden und Nitriden;
- ein Platinsilicid mit der Formel PtₓSi, wobei x eine Zahl größer oder gleich zwei darstellt, wobei sich dieses Silicid in der Form einer Schicht oder einer Vielzahl von Kontaktstellen zeigt, die voneinander beabstandet sind; und
- ein Graphenblatt.

17. Struktur nach Anspruch 16,
**dadurch gekennzeichnet, dass** das Diffusionssperrmaterial Siliciumdioxid ist.

18. Struktur nach Anspruch 16 oder Anspruch 17,
**dadurch gekennzeichnet, dass** das Graphenblatt mindestens zwei Graphenschichten umfasst.

19. Struktur, **dadurch gekennzeichnet, dass** diese ein Graphenblatt umfasst, wobei das Blatt, auf einer seiner Flächen, mit einem Platinsilicid mit der Formel PtₓSi versehen ist, wobei x eine Zahl größer oder gleich zwei darstellt, wobei sich dieses Silicid in der Form einer Schicht oder einer Vielzahl von Kontaktstellen zeigt, die voneinander beabstandet sind.

20. Verwendung einer Struktur, wie in einem der Ansprüche 16 bis 19 definiert, bei der Herstellung einer mikro- oder nanoelektronischen oder mikro- oder nanoelektromechanischen Vorrichtung.

## Claims

1. Method for synthesizing a graphene sheet on a platinum silicide of formula Pt*ₓ*Si wherein *x* is a number greater than or equal to two, which method is **characterized in that** it comprises:
a) producing a stack by:
i) depositing, on a substrate, a layer C1 of a diffusion barrier material chosen from oxides and nitrides;
ii) depositing, on the layer C1, a layer C2 of a carbon-containing material, said carbon-containing material optionally comprising silicon;
iii) depositing, on the layer C2, a layer C3 of platinum; and
iv) in case that the carbon-containing material used at sub-step ii) is free from silicon, depositing, on the layer C3, a layer C4 of a material of formula Si*ₐ*C*_{b}*H*_{c}* wherein *a* is a strictly positive number, whereas *b* and *c*, which are identical or different, are positive numbers or zero; then
b) heat treating the stack obtained at step a) at a temperature comprised between 200°C and 900°C;
and **in that** the carbon-containing material decomposes at the temperature at which the heat treatment is carried out and the ratio of the number of platinum atoms present in the layer C3 with respect to the number of silicon atoms present in the layer C2 or the layer C4 is greater than or equal to two.

2. Method according to claim 1, **characterized in that** the diffusion barrier material is silicon dioxide.

3. Method according to claim 1 or claim 2, **characterized in that** the carbon-containing material is chosen from amorphous carbon-containing materials.

4. Method according to claim 3, **characterized in that** the amorphous carbon-containing material comprises silicon in a proportion by mass greater than or equal to 20% of the total mass of said material.

5. Method according to claim 4, **characterized in that** the amorphous carbon-containing material comprises silicon in a proportion by mass greater than or equal to 40% of the total mass of said material.

6. Method according to claim 4 or claim 5, **characterized in that** the amorphous carbon-containing material comprising silicon is a hydrogenated amorphous silicon carbide of formula a-Si*_{α}*C*_{β}*:H wherein *α* and *β*, which are identical or different, are strictly positive numbers.

7. Method according to claim 6, **characterized in that** the hydrogenated amorphous silicon carbide has the formula a-Si*_{α}*C*_{β}*:H wherein *α* and *β* are both equal to 1.

8. Method according to claim 3, **characterized in that** the amorphous carbon-containing material is a material free from silicon.

9. Method according to claim 8, **characterized in that** the material free from silicon is hydrogenated amorphous carbon a-C:H.

10. Method according to any one of the preceding claims, **characterized in that** the layer C2 is deposited by plasma-enhanced chemical vapor deposition.

11. Method according to any one of the preceding claims, **characterized in that** the layer C3 is deposited by physical vapor deposition, at a temperature ranging from 20°C to 30°C.

12. Method according to claim 8 or claim 9, **characterized in that** the material of formula Si*ₐ*C*_{b}*H*_{c}* is hydrogenated amorphous silicon a-Si:H.

13. Method according to claim 12, **characterized in that** the layer of a-Si:H is deposited by plasma-enhanced chemical vapor deposition.

14. Method according to any one of claims 1 to 13, **characterized in that** the heat treatment is carried out at a temperature ranging from 750°C to 850°C, in a neutral atmosphere.

15. Method according to any one of claims 1 to 13, **characterized in that** the heat treatment comprises:
- a first heat treatment which is carried out at a temperature ranging from 250°C to 350°C, in a neutral atmosphere; and which is followed by
- a second heat treatment which is carried out at a temperature ranging from 750°C to 850°C, in a neutral atmosphere.

16. Structure, **characterized in that** it comprises in the following order:
- a substrate;
- a layer C1 of a diffusion barrier material chosen from oxides and nitrides;
- a platinum silicide of formula Pt*ₓ*Si wherein *x* is a number greater than or equal to two, this silicide being in the form of a layer or of a plurality of spaced pins; and
- a graphene sheet.

17. Structure according to claim 16, **characterized in that** the diffusion barrier material is silicon dioxide.

18. The structure according to claim 16 or claim 17, **characterized in that** the graphene sheet comprises at least two layers of graphene.

19. Structure, **characterized in that** it comprises a graphene sheet, said graphene sheet comprising, on one of its faces, a platinum silicide of formula Pt*ₓ*Si wherein *x* is a number greater than or equal to two, this silicide being in the form of a layer or of a plurality of spaced pins.

20. Use of a structure as defined in any one of claims 16 to 19, for manufacturing a micro- or nanoelectronic, or micro- or nanoelectromechanical device.
